# EUROPEAN PATENT APPLICATION

(11) **EP 1 933 398 A2**
(43) Date of publication of application: **18.06.2008**
(21) Application number: 07024075.9
(22) Date of filing: 12.12.2007
(51) Int. Cl.: H01L 51/52

(54) **Organic light emitting display device and method for fabricating the same**

(30) Priority: 15.12.2006 KR 20060128281
(71) Applicant: Samsung Electronics Co., Ltd., Seoul 442-742 (KR)
(72) Inventor: Kim, Hoon, Banwol-don Hwaseong-si Gyoenggi-do (KR); Koo, Won-Hoe, Yeongtong-gu Suwon-si Gyeonggi-do (KR); Choi, Jung-Mi, Giheung-gu Yongin-si Gyeinggi-do (KR)
(74) Representative: Dr. Weitzel & Partner

(57) **Abstract**

An organic light emitting display ("OLED") device includes a display substrate having an organic light emitting element, an encapsulation substrate covering the display substrate, an adhesive covering the organic light emitting element and adhering the display substrate to the encapsulation substrate, and a sealant containing frit to seal an edge region between the display substrate and the encapsulation substrate. A method for fabricating the OLED device is disclosed.

## Description

### CROSS-REFERENCE TO RELATED APPLICATION

This application claims priority from and the benefit of Korean Patent Application No. 10-2006-0128281, filed on December 15, 2006, which is hereby incorporated by reference for all purposes as if fully set forth herein.

### BACKGROUND OF THE INVENTION

FIELD OF THE INVENTION

The present invention relates to an organic light emitting display ("OLED") device and a method for fabricating the same, and more particularly, to an OLED device in which a display substrate and an encapsulation substrate are sealed with a sealant, and a method for fabricating the OLED device.

DISCUSSION OF THE BACKGROUND

An OLED device includes pixels arranged in a matrix form. Each pixel may include three sub-pixels respectively displaying red, green, and blue light. Each sub-pixel includes an organic light emitting cell and a cell driving portion for individually driving the organic light emitting cell. The organic light emitting cell includes an anode connected to the cell driving portion, a cathode connected to a ground, and a light emitting layer arranged between the anode and the cathode. The cell driving portion includes a gate line for supplying a scan signal, a data line for supplying a data signal, a driving thin film transistor (TFT), a switching TFT, and a storage capacitor connected to a power line for supplying a power signal.

The OLED device includes an encapsulation layer for keeping moisture and oxygen out of the light emitting layer since its life span may be shortened by exposure to these elements. However, the conventional encapsulation layer and the conventional method for encapsulating the light emitting layer may not effectively keep moisture and oxygen out of the light emitting layer, and also may be difficult to apply to a larger substrate.

### SUMMARY OF THE INVENTION

The present invention provides an OLED device in which a display substrate and an encapsulation substrate coated with an adhesive are attached to each other and their edges are sealed, and a method for fabricating the OLED device.

Additional features of the invention will be set forth in the description which follows, and in part will be apparent from the description, or may be learned by practice of the invention.

The present invention discloses an organic light emitting display ("OLED") device including a display substrate, an organic light emitting element arranged on the display substrate, a encapsulation substrate covering the display substrate, an adhesive covering the organic light emitting element and adhering the display substrate to the encapsulation substrate, and a sealant arranged on an edge region of the display substrate to seal a gap between the display substrate and the encapsulation substrate and including frit.

The present invention also discloses a method for fabricating an organic light emitting display ("OLED") device, including forming an organic light emitting element on a display substrate, forming a sealant including frit on an edge region of a encapsulation substrate, coating an adhesive on a portion of the encapsulation substrate spaced apart from and inside the sealant, attaching the display substrate and the encapsulation substrate, curing the adhesive, and melting the sealant to adhere the display substrate to the encapsulation substrate.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.

FIG. 1 is a cross-section view illustrating an OLED device according to an exemplary embodiment of the present invention.

FIG. 2 is a plan view illustrating an organic light emitting element according to an exemplary embodiment of the present invention.

FIG. 3 is a cross-section view of the organic light emitting element taken along line I-I' shown in FIG. 2.

FIG. 4 is a partial cross-section view illustrating an edge portion of the OLED device according to an exemplary embodiment of the present invention.

FIG. 5 is a partial cross-section view illustrating an edge portion of the OLED device according to an exemplary embodiment of the present invention.

FIG. 6, FIG. 7, FIG. 8, FIG. 9, and FIG. 10 are cross-section views illustrating a method for fabricating the OLED device according to an exemplary embodiment of the present invention.

FIG. 11 is a cross-section view illustrating a method for curing a sealant according to an exemplary embodiment of the present invention.

### DETAILED DESCRIPTION OF THE ILLUSTRATED EMBODIMENTS

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure is thorough, and will fully convey the scope of the invention to those skilled in the art. In the drawings, the size and relative size of layers and regions may be exaggerated for clarity. Like reference numerals in the drawings denote like elements.

It will be understood that when an element such as a layer, film, region or substrate is referred to as being "on", "connected to", or "coupled to" another element or layer, it can be directly on, directly connected to, or directly coupled to the other element or layer, or intervening elements or layers may also be present. In contrast, when an element is referred to as being "directly on", "directly connected to", or "directly coupled to" another element or layer, there are no intervening elements or layers present.

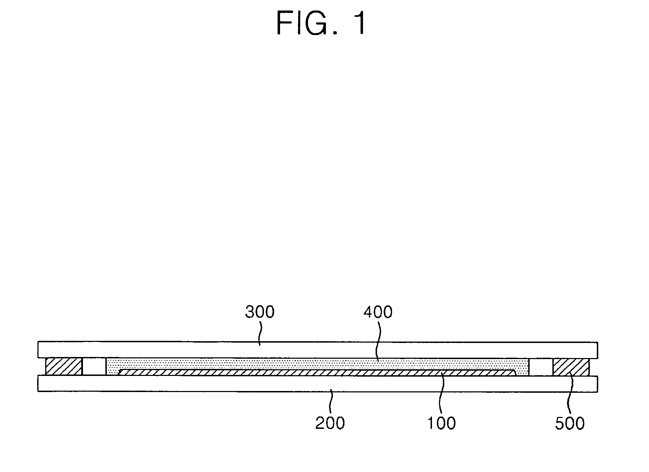

FIG. 1 is a cross-section view illustrating an OLED device according an exemplary embodiment of the present invention. The OLED device of FIG. 1 includes a display substrate 200, an encapsulation substrate 300, an adhesive 400, an organic light emitting element 100, and a sealant 500.

The display substrate 200 is an insulating substrate on which the organic light emitting element 100 is arranged. The display substrate 200 may be a glass substrate or a flexible plastic substrate. The display substrate 200 is divided into a display region on which the organic light emitting element 100 is arranged to display an image and a non-display region where the organic light emitting element 100 is not arranged. The display region may be a center region of the display substrate 200, whereas the non-display region may be an edge portion of the display substrate 200. Since the OLED device is more beneficial as the display region is larger, the display region may occupy a greater portion of the display substrate 200, and the non-display region may occupy a relatively smaller region.

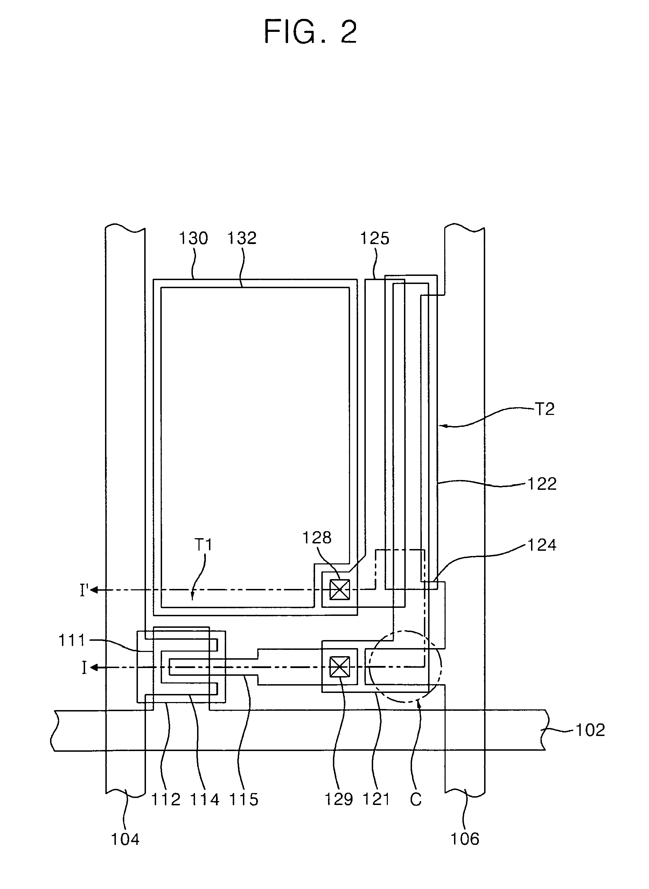

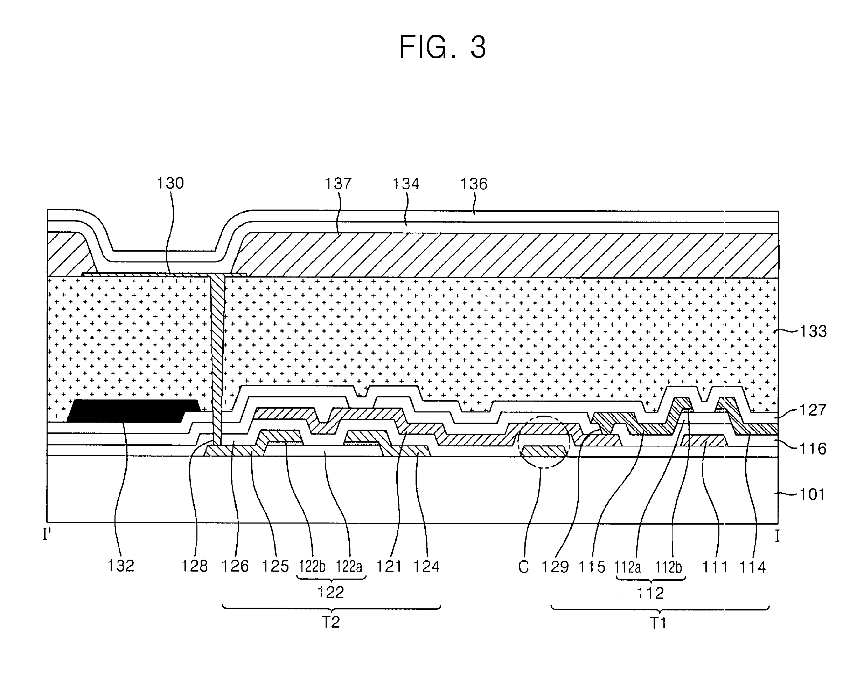

FIG. 2 is a plan view illustrating an organic light emitting element according to an exemplary embodiment of the present invention, and FIG. 3 is a cross-section view of the organic light emitting element taken along line I-I' shown in FIG. 2.

An organic light emitting element according to an exemplary embodiment of the present invention is described below in detail with reference to FIG. 2 and FIG. 3.

The organic light emitting element 100 according to an exemplary embodiment of the present invention includes an organic light emitting cell and a cell driving portion.

The cell driving portion includes a gate line 102, a data line 104, a power line 106, a switching TFT T1, a driving TFT T2, and a storage capacitor C arranged on a substrate 101.

The gate line 102 supplies a scan signal and is connected to a first gate electrode 111 of the switching TFT T1. The data line 104 supplies a data signal and is connected to a first source electrode 114 of the switching TFT T1. The power line 106 supplies a power signal and is connected to a second source electrode 124 of the driving TFT T2.

The switching TFT T1 is turned on by a scan pulse supplied to the gate line 102, and transmits a data signal from the data line 104 to the storage capacitor C and a second gate electrode 121 of the driving TFT T2.

The switching TFT T1 includes the first gate electrode 111 extending from the gate line 102, the first source electrode 114 extending from the data line 104, a first drain electrode 115 arranged opposite to the first source electrode 114 and connected to a second gate electrode 121 of the driving TFT T2 and the storage capacitor C, and a first semiconductor pattern 112. The first semiconductor pattern 112 forms a channel area between the first source electrode 114 and the first drain electrode 115.

The first semiconductor pattern 112 includes a first active layer 112a overlapping the gate electrode 111 with a gate insulating layer 116 arranged therebetween, and a first ohmic contact layer 112b arranged on the first active layer 112a except in a region corresponding to the channel area. The first ohmic contact layer 112b creates an ohmic contact with the first source electrode 114 and the first drain electrode 115.

The first active layer 112a may be made of amorphous silicon or polysilicon. The first active layer 112a may be made of amorphous silicon to have good on-off switching characteristics.

The driving TFT T2 controls an electric current to be supplied from the power line 106 to the organic light emitting cell in response to a data signal supplied to the second gate electrode 121, to thereby adjust the amount of light emitting from the organic light emitting cell.

The driving TFT T2 includes the second gate electrode 121 connected to the first drain electrode 115 of the switching TFT T1, a second source electrode 124 connected to the power line 106, a second drain electrode 125 arranged opposite to the second source electrode 124 and connected to the anode 130 of the organic light emitting cell, and a second semiconductor pattern 122. The second semiconductor pattern 122 forms a channel area between the second source electrode 124 and the second drain electrode 125.

The second semiconductor pattern 122 includes a second active layer 122a overlapping the gate electrode 121 and having a second gate insulating layer 126 arranged therebetween, and a second ohmic contact layer 122b arranged on the second active layer 122a except in regions corresponding to the channel area. The second ohmic contact layer 122b creates an ohmic contact with the second source electrode 124 and the second drain electrode 125.

The second active layer 122a may be made of amorphous silicon or polysilicon. The second active layer 122a may be made of polysilicon for providing a longer lifespan since electric current flows through the second active layer 122a during a light emitting period of the organic light emitting cell.

If the second active layer 122a is made of polysilicon, the driving TFT T2 may have a top gate structure in which the second gate electrode 121 is arranged on a top portion of the driving TFT T2 as shown in FIG. 3.

In the present exemplary embodiment, the first drain electrode 115 of the switching TFT T1 and the second gate electrode 121 of the driving TFT T2 are made of the same material and are connected to each other via a second contact hole 129. Thus, fabrication is simplified and contact resistance may be reduced since the first drain electrode 115 and the second gate electrode 121 are made of the same material and may be directly connected to each other without using a separate connecting electrode.

The second drain electrode 125 of the driving TFT T2 is exposed by a first contact hole 128 and is connected to the anode 130 of the organic light emitting cell via the first contact hole 128.

The storage capacitor C includes a region where the power line 106 and the second gate electrode 121 of the driving TFT T2 overlap with each other, with the second gate insulating layer 126 arranged therebetween. Accordingly, even if the switching TFT T1 is turned off, a voltage charged in the storage capacitor C may permit the driving TFT T2 to supply an electric current to the anode 130 until a data signal for the next frame is supplied, thereby continuously emitting light from the organic light emitting cell.

A passivation layer 127 is arranged on the substrate 101 including the switching TFT T1, the driving TFT T2 and the storage capacitor C. The passivation layer 127 may be made of an inorganic insulating material such as SiNx or SiOx to prevent TFT deterioration.

The organic light emitting cell includes a color filter 132, an anode 130, a light emitting layer 134, and a cathode 136. The color filter 132 receives white light emitted from the light emitting layer 134 to realize light having an appropriate color. Generally, a color filter 132 that realizes red, green or blue light is arranged on one sub-pixel, and three sub-pixels having color filters 132 that each realize a different color are included in one pixel.

An organic planarization layer 133 may be arranged on the color filter 132 since the color filter 132 may have a rough surface due to material characteristics. If a thin anode 130 is arranged directly on a rough surface of a color filter 132, it may be difficult to form the anode 130 with a uniform thickness. Thus, a short circuit may occur between the anode 130 and the cathode 136, or there may be discontinuities in the anode 130.

Alternatively, light emitting layers 134 that emit light having different colors according to pixels or sub-pixels may be used instead of the color filter 132.

The organic planarization layer 133, the passivation layer 127, the first gate insulating layer 116, and the second gate insulating layer 126 include the first contact hole 128 to expose the second driving electrode 125 of the driving TFT T2 as shown in FIG. 3.

The anode 130 is connected to the second drain electrode 125 of the driving TFT T2 to receive a power signal, and supplies holes. The anode 130 may be made of a transparent conductive material such as indium tin oxide (ITO), indium zinc oxide (IZO), or indium tin zinc oxide (ITZO).

A wall 137 is arranged to cover an edge of the anode 130 and to expose the remaining portion of the anode 130. The wall 137 covers the edge of the anode 130 to prevent a short circuit between the anode 130 and the cathode 136, and covers the switching TFT T1 and the driving TFT T2 to protect the cell driving portion. If the light emitting layers 134 that realize different colors are used, the wall 137 may define each pixel region and may prevent the light emitting layers 134 of different pixels from mixing.

According to the present exemplary embodiment, the light emitting layer 134 emits white light toward the color filter 132 through the anode 130 according to the amount of an electric current supplied to the anode 130. The light emitting layer 134 is made of a polymer or small molecular weight organic light emitting material. In the present exemplary embodiment, the light emitting layer 134 is arranged on the entire substrate 101 of the organic light emitting element 100. More specifically, the light emitting layer 134 is not arranged individually per pixel, but is arranged over the entire substrate 101 of the organic light emitting element 100. Since the light emitting layer 134 emits white light, the light emitting layer 134 may include sequentially stacked light emitting materials that realize red (R), green (G) and blue (B) to form a three-layered structure, stacked light emitting materials that have a complementary color relationship to form a two-layer structure, or a light emitting layer 134 that realizes white color to form a single-layer structure.

Alternatively, the light emitting layer 134 may be arranged separately for each pixel. In this instance, a mask (not shown) may be used for dividing the light emitting layer 134 according to the pixels so that different light emitting layers 134 can be formed for each pixel.

A hole injecting layer (not shown), a hole transporting layer (not shown), an electron transporting layer (not shown), and an electron injecting layer (not shown) may be additionally arranged between the anode 130 and the cathode 136 to improve light emitting characteristics and light emitting efficiency of the light emitting layer 134.

The cathode 136 is arranged on the light emitting layer 134. The cathode 136 supplies electrons and reflects white light emitted from the light emitting layer 134 toward the color filter 132. Thus, the cathode 136 may be made of a material having an excellent electron-supplying ability and high reflectivity, such as aluminum or an aluminum alloy.

The display region of the display substrate 200 on which the organic light emitting element 100 is arranged is covered with an adhesive 400 as shown in FIG. 1. The adhesive 400 covers the organic light emitting element 100 to prevent moisture or oxygen infiltration into the organic light emitting element 100, which may increase a lifespan of the organic light emitting element 100. In the present exemplary embodiment, the adhesive 400 contains an epoxy-based material and allows the display substrate 200 to adhere more uniformly to the encapsulation substrate 300.

As shown in FIG. 1, the display substrate 200 is covered with the encapsulation substrate 300. The encapsulation substrate 300 is adhered to the display substrate 200 by the adhesive 400. An adhesive 400 made of an epoxy-based material may not keep moisture or oxygen entirely out of the air because it may include small pores, but moisture or oxygen can be effectively kept out by the encapsulation substrate 300. Therefore, the encapsulation substrate 300 may be made of glass to keep moisture or oxygen out of the air.

The sealant 500 seals an edge portion between the display substrate 200 and the encapsulation substrate 300. Even though the encapsulation substrate 300 keeps out moisture or oxygen, if a gap exists between the display substrate 200 and the encapsulation substrate 300, moisture or oxygen may penetrate into the gap. Thus, the edge portion between the display substrate 200 and the encapsulation substrate 300 is sealed with the sealant 500. The sealant 500 may form a closed curve to more effectively seal the edge portion between the display substrate 200 and the encapsulation substrate 300.

In this exemplary embodiment, the sealant 500 is made of a glass-like material that can effectively keep out moisture or oxygen. For example, the sealant 500 may contain frit. The frit may include a low-temperature glass frit which contains one or more absorbing ions such as iron, copper, vanadium, and neodymium. The frit may be doped with a filling material to lower a thermal expansion coefficient of the frit, so that the frit can conform to or substantially match a thermal expansion coefficient of the display substrate 200 or the encapsulation substrate 300. The filling material may be a convertible filling material or an additional filling material.

The sealant 500 is spaced apart from the adhesive 400 as shown in FIG. 1. Since a sealant 500 made of glass may be heated at a high temperature during a melting process, if the sealant 500 and the adhesive 400 contact each other or are arranged substantially adjacent to each other, the adhesive 400 or the organic light emitting element 100 may become damaged while curing the sealant 500.

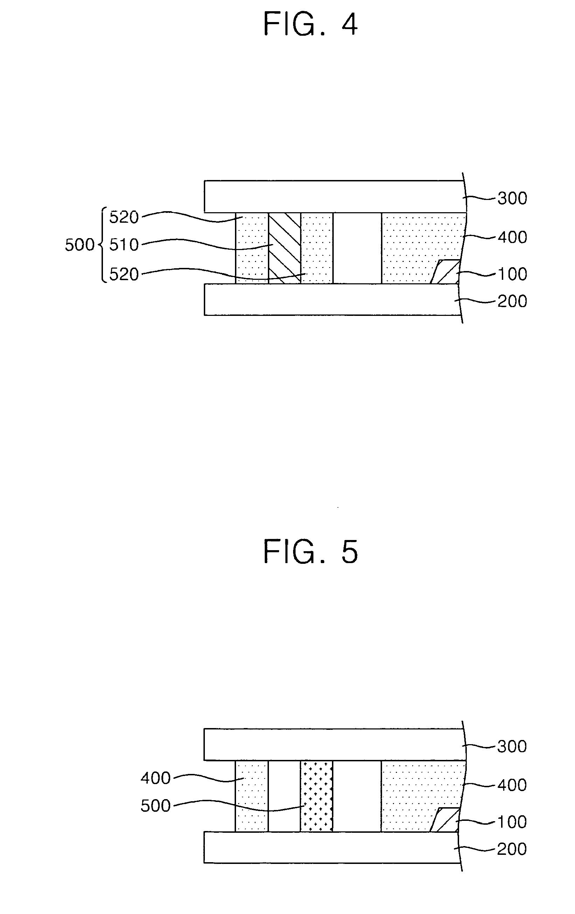

FIG. 4 is a partial cross-section view illustrating an edge portion of the OLED device according to exemplary embodiments of the present invention.

Referring to FIG. 4, the sealant 500 may include a central portion 510 and outer portions 520. The central portion 510 of the sealant 500 is a portion that is melted by a laser beam and then cured again to couple the display substrate 200 and the encapsulation substrate 300. The outer portion 520 is a portion that is not melted by the laser beam and extends from both sides of the central portion 510 where the display substrate 200 and the encapsulation substrate 300 are not yet adhered to each other. That is, when adhering the display substrate 200 and the encapsulation substrate 300, only the central portion 510 of the sealant 500 is melted. Since a relatively small area of the sealant 500 is heated, the possibility that the display substrate 200 or the organic light emitting element 100 become damaged during the adhering step may be lower.

Referring to FIG. 5, the adhesive 400 may be arranged on the display region and a portion of the non-display region of the display substrate 200. The adhesive 400 is arranged on the display region in which the organic light emitting element 100 is arranged to protect the organic light emitting element 100, and it is further arranged along a portion of the edge portion outside the sealant 500. The adhesive 400 arranged on the non-display region reinforces the mechanical strength of the edge portion of the display substrate 200 and the encapsulation substrate 300. Thus, it more firmly couples the display substrate 200 and the encapsulation substrate 300.

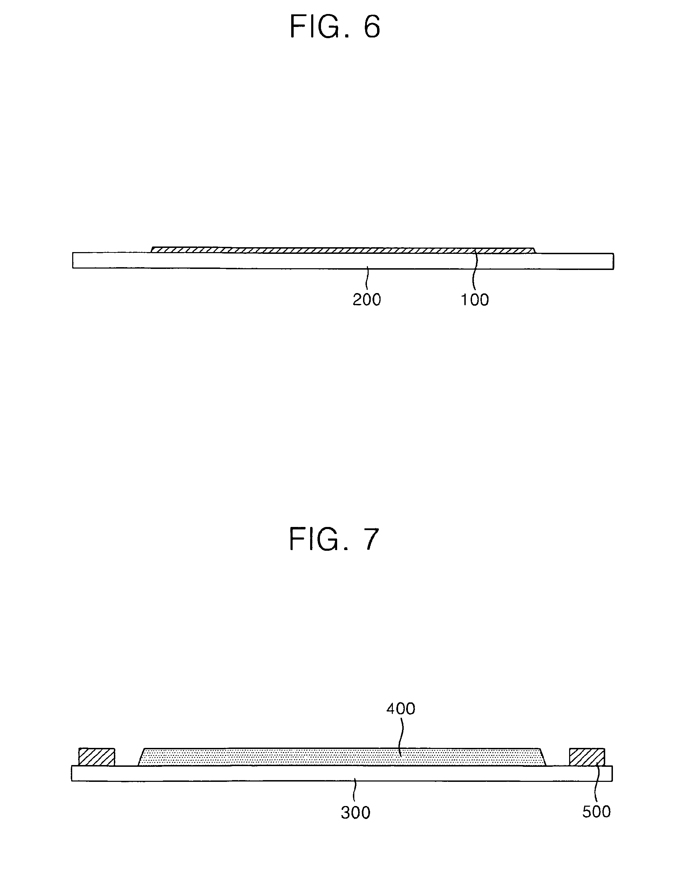

FIG. 6, FIG. 7, FIG. 8, FIG. 9, and FIG. 10 are cross-section views illustrating a method for fabricating the OLED device according to an exemplary embodiment of the present invention.

A method for fabricating the OLED device according to an exemplary embodiment of the present invention is described below with reference to FIG. 6, FIG. 7, FIG. 8, FIG. 9, and FIG. 10.

As shown in FIG. 6, the organic light emitting element 100 is formed on the display substrate 200. A method for forming the organic light emitting element 100 may include forming the cell driving portion and forming the organic light emitting cell. A method for forming the cell driving portion may be substantially similar or identical to a method for forming a TFT, and a method for forming the organic light emitting cell may be substantially similar or identical to a method using a thermal deposition technique, and thus detailed descriptions of those methods will be omitted.

As shown in FIG. 7, the sealant 500 is formed on the edge portion of the encapsulation substrate 300. The glass frit used as a sealant 500 is coated along a sealing line of the edge portion of the encapsulation substrate 300. Since it may result in a larger aperture ratio, the sealing line is formed on the outer-most portion of the encapsulation substrate 300. The sealant 500 may be coated at a distance of about 1 mm from an outer edge of the encapsulation substrate 300. The glass frit may be coated by using a dispensing or printing technique.

The coated glass frit is cured through a sintering step. That is, the glass frit coated on the encapsulation substrate 300 is heated at a predetermined temperature or to a predetermined temperature to evaporate a solvent and to sinter the frit.

Then, the adhesive 400 is coated on the encapsulation substrate 300. The adhesive 400 is coated inside the sealant 500. The adhesive 400 is spaced apart from the sealant 500 as shown in FIG. 7. Since an epoxy-based adhesive 400 is used, the adhesive can be more uniformly coated over a larger substrate in a short time.

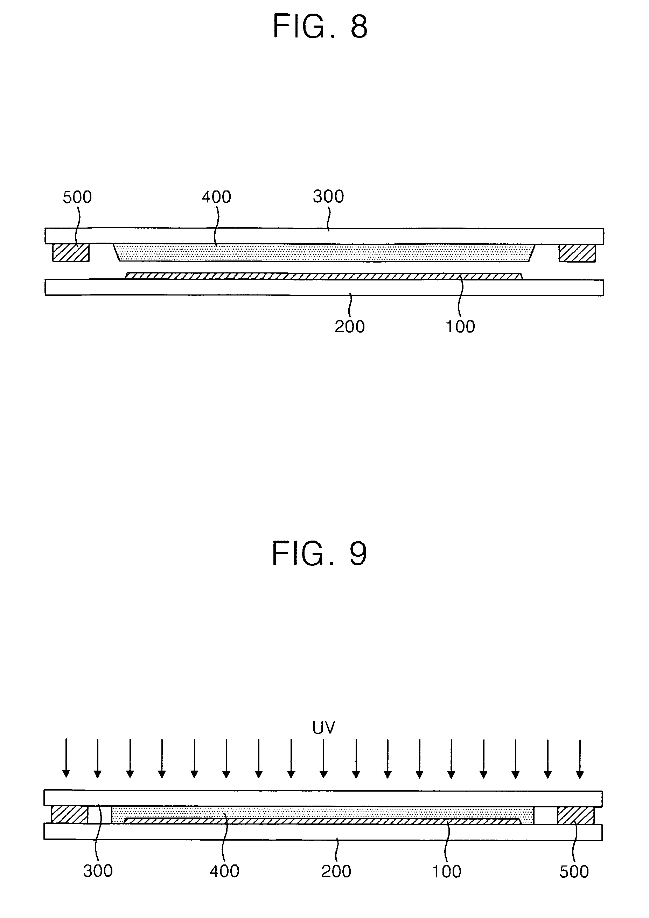

Subsequently, as shown in FIG. 8, the display substrate 200 and the encapsulation substrate 300 are attached to each other. Attaching the display substrate 200 and the encapsulation substrate 300 may include a step for accurately aligning the display substrate 200 and the encapsulation substrate 300 and a step for transporting, pressurizing, and attaching the display substrate 200 and the encapsulation substrate 300.

The step for aligning the display substrate 200 and the encapsulation substrate 300 may be important for an accurate sealing. Marks (not shown) for an accurate alignment may be formed on edges of the display substrate 200 and the encapsulation substrate 300, and the aligning step may be performed by using the marks. The aligning step is performed so the display substrate 200 and the encapsulation substrate 300 are positioned close to each other so that the alignment does not change during the attaching step.

The aligning step may be performed either in a vacuum environment or in an atmospheric pressure environment. If the attaching step is performed in a vacuum environment, the aligning step may be performed in the same vacuum environment. This is to prevent the aligned substrates from being misaligned while transporting the aligned substrates or changing the pressure.

Further, pressurizing and attaching the display substrate 200 and the encapsulation substrate 300 may be performed in a vacuum environment. If pressurizing and attaching the display substrate 200 and the encapsulation substrate 300 is performed in an atmospheric pressure environment, some air may remain in the adhesive 400 or between the adhesive 400 and the display substrate 200. The moisture or oxygen in the air may deteriorate the organic light emitting element 100 during the use of the OLED device. The risk of air in the adhesive 400 or between the adhesive 400 and the display substrate 200 can be reduced by attaching the display substrate 200 and the encapsulation substrate 300 in a vacuum chamber.

The display substrate 200 and the encapsulation substrate 300 may be uniformly pressurized so that the adhesive can be distributed at a more uniform thickness over the whole surface between the display substrate 200 and the encapsulation substrate 300.

Next, as shown in FIG. 9, the adhesive 400 may be cured. Since epoxy is used as the adhesive 400 in this exemplary embodiment, either a thermal curing technique or an ultraviolet ("UV") light curing technique can be used. That is, the adhesive 400 is cured by irradiating the adhesive 400 with UV light or heating the adhesive 400 while the display substrate 200 and the encapsulation substrate 300 are attached together. If necessary, a portion of the adhesive 400 can be selectively irradiated by the UV light.

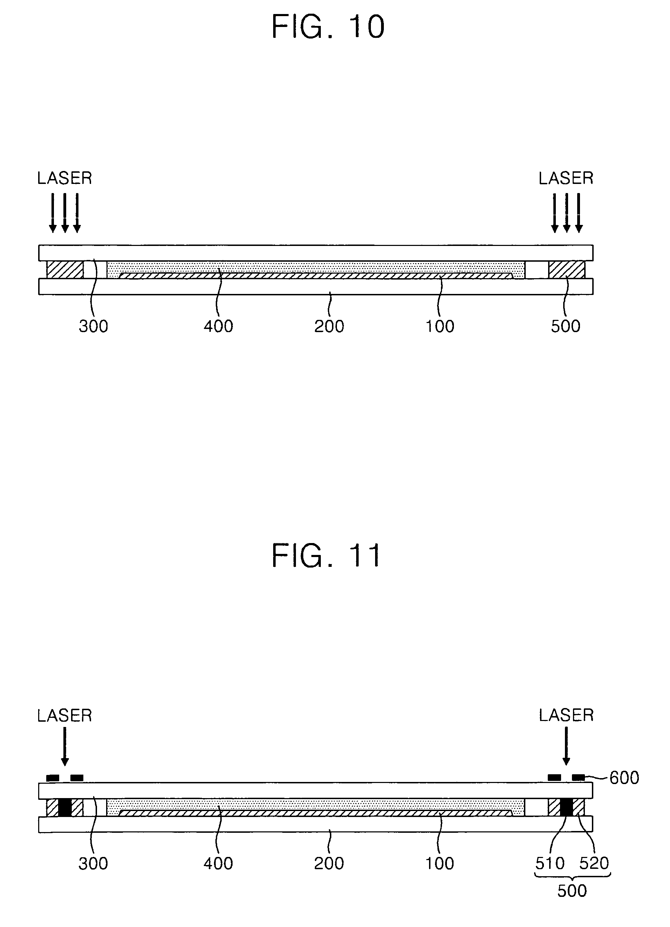

As shown in FIG. 10, after curing the adhesive 400, the sealant 500 is melted to adhere and seal the display substrate 200 and the encapsulation substrate 300. A laser beam is irradiated to melt the sealant 500 arranged between the display substrate 200 and the encapsulation substrate 300 and to cure the sealant 500 again, thereby sealing the edge portion between the display substrate 200 and the encapsulation substrate 300. In this exemplary embodiment, a line-shaped laser beam may be used to melt the sealant 500 and to adhere the display substrate 200 and the encapsulation substrate 300.

Alternatively, a laser beam may be simultaneously irradiated to all edge portions on which the sealant 500 is distributed, thereby completing the adhering step in a single step.

Meanwhile, the display substrate 200 or the organic light emitting element 100 may become damaged during the laser curing. Accordingly, the display substrate 200 and the organic light emitting element 100 may be cooled to maintain a temperature of less than about 100°C during the adhering step.

FIG. 11 is a cross-section view illustrating a method for curing a sealant according to an exemplary embodiment of the present invention.

As shown in FIG. 11, a central portion 510 of the sealant 500 can be melted to adhere the display substrate 200 to the encapsulation substrate 300. The outer portions 520 of the sealant 500 may not be melted during this method. A laser beam having a narrow width may be used, or a mask 600 may be used as shown in FIG. 11. The mask 600 exposes only the central portion 510 of the sealant 500 and is arranged on the encapsulation substrate 300, and then a laser beam is irradiated to melt the central portion 510 of the sealant 500. If only the central portion 510 is melted, an area of the sealant 500 that is irradiated by the laser beam is smaller, and a possibility that the organic light emitting element 100 or the adhesive 400 become damaged during the adhering step may be reduced.

As described above, according to the present invention, since the display substrate 200 is encapsulated by the encapsulation substrate 300 on which the adhesive 400 is uniformly coated over the whole surface, the encapsulation method can be more uniformly performed for larger substrates.

In addition, since the edge portions of the display substrate 200 and the encapsulation substrate 300 are sealed by the sealant 500, an invasion of moisture or oxygen can be more effectively prevented, thereby increasing a lifespan of the OLED device.

It will be apparent to those skilled in the art that various modifications and variation can be made in the present invention without departing from the spirit or scope of the invention. Thus, it is intended that the present invention cover the modifications and variations of this invention provided they come within the scope of the appended claims and their equivalents.

## Claims

1. An organic light emitting display ("OLED") device, comprising:
a display substrate;
an organic light emitting element arranged on the display substrate;
an encapsulation substrate covering the display substrate;
an adhesive covering the organic light emitting element and adhering the display substrate to the encapsulation substrate; and
a sealant arranged on an edge region of the display substrate to seal a gap between the display substrate and the encapsulation substrate and comprising frit.

2. The OLED device of claim 1, wherein the sealant is spaced apart from the adhesive.

3. The OLED device of claim 1, wherein the sealant comprises a central portion, a first outer portion extending from a first side of the central portion, and a second outer portion extending from a second side of the central portion, and
wherein the display substrate and the encapsulation substrate are adhered to the sealant in a central region corresponding to the central portion, and are not adhered to the sealant in a first side region corresponding to the first outer portion and a second side region corresponding to the second outer portion.

4. The OLED device of claim 1, wherein the adhesive comprises an epoxy-based material.

5. The OLED device of claim 4, wherein the adhesive is arranged in a display region.

6. The OLED device of claim 4, wherein the adhesive is arranged in a non-display region of the encapsulation substrate.

7. The OLED device of claim 4, further comprising an outer adhesive arranged outside the sealant on an edge region of the encapsulation substrate.

8. A method for fabricating an organic light emitting display ("OLED") device, comprising:
forming an organic light emitting element on a display substrate;
forming a sealant comprising frit on an edge region of an encapsulation substrate; coating an adhesive on a portion of the encapsulation substrate spaced apart from and inside the sealant;
attaching the display substrate to the encapsulation substrate;
curing the adhesive; and
melting the sealant to adhere the display substrate to the encapsulation substrate.

9. The method of claim 8, wherein forming the sealant comprises:
coating glass frit along a sealing line of the encapsulation substrate; and
heating the glass frit to be sintered.

10. The method of claim 8, wherein melting the sealant comprises irradiating the sealant with a laser beam.

11. The method of claim 10, wherein the laser beam comprises a line-shaped laser beam.

12. The method of claim 10, wherein melting the sealant comprises irradiating all sealant on the edge region simultaneously with a laser beam.

13. The method of claim 10, further comprising shielding a first portion of the sealant from the laser beam.

14. The method of claim 13, wherein a second portion of the sealant is irradiated with the laser beam.

15. The method of claim 12, further comprising cooling the display substrate and the organic light emitting element to a temperature of 100 °C or less.

16. The method of claim 8, wherein the adhesive comprises an epoxy-based material.

17. The method of claim 16, wherein curing the adhesive comprises heating the adhesive.

18. The method of claim 16, wherein curing the adhesive comprises irradiating the adhesive to be cured with ultraviolet light.

19. The method of claim 8, wherein attaching the substrates is performed in a vacuum environment.
